# EUROPEAN PATENT APPLICATION

(11) **EP 2 600 383 A1**
(43) Date of publication of application: **05.06.2013**
(21) Application number: 11811978.3
(22) Date of filing: 15.06.2011
(51) Int. Cl.: H01J 37/20

(54) **STAGE APPARATUS**

(30) Priority: 28.07.2010 JP 2010168774
(71) Applicant: Hitachi High-Technologies Corporation, Tokyo 105-8717 (JP)
(72) Inventor: MOMOI, Yasuyuki, Hitachi-shi Ibaraki 319-1292 (JP); TAKEUCHI, Koichiro, Hitachinaka-shi Ibaraki 312-8504 (JP); TAKAHASHI, Kaname, Hitachinaka-shi Ibaraki 312-8504 (JP); HANEDA, Shigeru, Hitachinaka-shi Ibaraki 312-8504 (JP)
(74) Representative: Moore, Graeme Patrick
(86) International application number: PCT/JP2011/003396
(87) International publication number: WO 2012/014371

(57) **Abstract**

Fluctuation in speed when a stage with a sample mounted thereon is moved at low speed is reduced such that an image to be observed is moved at constant speed when performing high-magnification observation using a scanning electron microscope. A control amount is obtained by compensation means from the deviation between position information obtained from position information detected by position detection means through a first low-pass filter and a command value obtained by integrating a speed command value input from stage operation input means and through a second low-pass filter having the same frequency characteristic as the first low-pass filter, and a driving signal to be output to driving means is generated from the added value of the control amount and the speed command value by waveform output means.

## Description

### Technical Field

The present invention relates to a stage which is moved with a sample to be observed mounted thereon to move an observation field of view in a charged particle beam apparatus, such as a scanning electron microscope.

### Background Art

A scanning electron microscope (hereinafter, referred to as SEM) which is a representative charged particle beam apparatus is used for observation of defects or faults in a semiconductor pattern. In recent years, with miniaturization of semiconductor processes, in the scanning electron microscope, observation at higher magnification is required. The scanning electron microscope emits an electron beam (primary electron beam) onto the surface of a sample to be observed while scanning in a two-dimensional shape, and sets the intensity of a secondary electron secondarily generated from the sample as a luminance modulation input of an image scanned and generated in synchronization with scanning of the primary electron beam to acquire an image (SEM image) to be observed of the sample surface. At this time, a sample surface to be observed is selected by moving a stage with a sample mounted thereon in the scanning electron microscope. Usually, an operator operates operation input means, such as a trackball, while viewing the SEM image, and moves the stage until an intended sample surface portion is obtained as an SEM image. In this case, in order for the operator to easily recognize a current observation position, it is preferable to move the stage at constant speed such that the SEM image moves at constant speed. When observing a sample, such as a semiconductor wafer, in which the same fine patterns (cells) are continuous, a method which measures the number of cells passing across an SEM screen using visual observation or image processing (cell count), and determines whether or not an intended portion has been reached is used. In this case, it is necessary to move the stage at constant speed such that the SEM image is moved at constant speed without oversight of cells.

As a method of operating the stage at constant speed, a method which uses open control to directly provide a driving signal for moving the stage at constant speed to driving means for driving the stage, or a method using speed feedback control is known. In regard to the method using speed feedback control, a method which obtains speed through differentiation of position information obtained by position detection means and feeds back the speed, and a method which estimates speed using a status observer from the position information obtained by the position detection means and feeds back the speed as disclosed in PTL 1 are known.

### Citation List

### Patent Literature

PTL 1: JP-A-2006-72941

### Summary of Invention

### Technical Problem

In the method using open control of the related art, deviation from a target speed or fluctuation in speed may occur due to friction of a slide portion of a stage mechanism, a load applied to the stage, deformation of the driving means/a driving force transmission system, or the like.

Even if speed feedback control is performed, when the related art is applied to an electron microscope which is used for observation at high magnification, the following problems occur. As means for detecting the position of the stage, a position sensor, such as a linear scale, is used. A sensor head moves on the scale with slits at regular intervals, a pulse is generated each time the sensor head passes above each slit, and the number of pulses is measured to acquire the position. When observation is performed at high magnification, even if the stage moves on the SEM image at the same speed, it is necessary to move the stage slowly for an amount corresponding to observation magnification. When the stage moves at low speed, since the generation time interval of the pulses generated by the position sensor is extended, a stepwise speed may be required despite an intrinsically constant speed. Since pulse variation due to noise increases compared to pulse variation due to the movement of the stage, errors in speed to be required increase, and noise of a high-frequency component may be mixed. For these reasons, it becomes difficult to reduce fluctuation in speed or errors in speed at low speed.

Accordingly, an object of the invention is to provide a stage apparatus capable of reducing fluctuation in speed at low speed.

### Solution to Problem

In order to attain the above-described object, the invention provides a stage apparatus including a stage which moves with a sample mounted thereon, driving means for driving the stage, position detection means for detecting the position of the stage, stage operation input means for operating the stage, stage control means for controlling the stage in accordance with an input from the stage operation input means, a first low-pass filter which processes position information detected by the position detection means, an integrator which integrates a speed command value input from the stage operation input means, a second low-pass filter which processes the output of the integrator and has the same frequency characteristic as the first low-pass filter, compensation means for performing control computation from the deviation between the output of the first low-pass filter and the output of the second low-pass filter, waveform output means for generating a driving signal to be input to the driving means from the addition value of the output of the compensation means and the speed command value, and an amplifier which amplifies the output of the waveform output means and outputs the result to the driving means.

The frequency characteristics of the first low-pass filter and the second low-pass filter may change depending on the speed command value.

Parameters, such as a gain, of the compensation means may change depending on the speed command value.

The stage apparatus may further include speed command value generation means for generating the speed command value from a position command value input from the stage operation input means and the output of the first low-pass filter, wherein the speed command value may be used as an input to the integrator.

### Advantageous Effects of Invention

According to the invention, it is possible to provide a stage apparatus capable of reducing fluctuation in speed at low speed. It also becomes possible to achieve improvement of delay in response.

### Brief Description of Drawings

[Fig. 1] Fig. 1 is a configuration diagram of a stage apparatus of the invention.
[Fig. 2] Fig. 2 is a configuration diagram of a scanning electron microscope which uses a stage apparatus.
[Fig. 3] Fig. 3 is a diagram of a mechanism configuration of a stage.
[Fig. 4] Fig. 4 is a schematic view illustrating an example of driving means of a stage.
[Fig. 5] Fig. 5 is a diagram illustrating an example of a driving signal which is provided to driving means.
[Fig. 6] Fig. 6 is a diagram illustrating processing of waveform output means.
[Fig. 7] Fig. 7 is a diagram illustrating the effect of a stage apparatus of the invention compared to a stage apparatus using open control of the related art.
[Fig. 8] Fig. 8 is a diagram illustrating the effect of feedforward of a speed command value in a stage apparatus of the invention.
[Fig. 9] Fig. 9 is another configuration diagram of a stage apparatus of the invention.
[Fig. 10] Fig. 10 is a diagram illustrating speed command value generation means.

### Description of Embodiments

Hereinafter, an embodiment of the invention will be described with reference to the drawings.

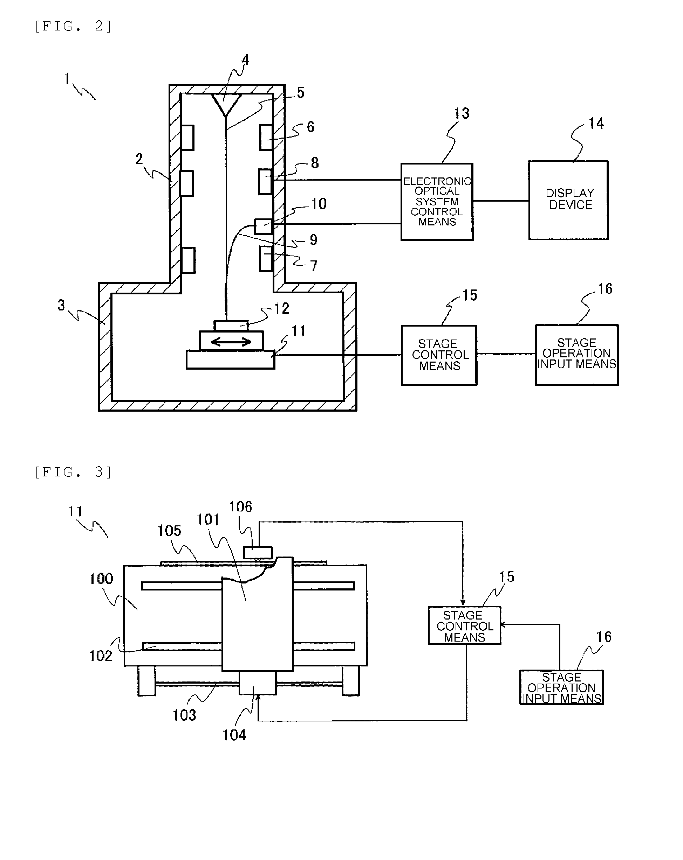

The configuration of a scanning electron microscope which uses a stage apparatus of this example will be described with reference to Fig. 2. A scanning electron microscope 1 includes a lens barrel 2 having an electronic optical system, a sample chamber 3, a stage 11, and the like. A primary electron beam 5 generated from an electron gun 4 is emitted onto a sample 12 through a convergence lens 6 and an objective lens 7, and a secondary electron 9 generated from the sample 12 to be observed is detected by a secondary electron detector 10. The primary electron beam 5 scans the surface of the sample 12 in a two-dimensional shape by a scanning polarizer 8. Electronic optical system control means 13 controls the scanning of the primary electron beam 5 using the scanning polarizer 8, and sets the intensity of the secondary electron 9 detected by the secondary electron detector 10 as a luminance modulation input of an image scanned and generated in synchronization with the scanning of the primary electron beam to generate an image (SEM image) to be observed of the sample surface. The generated SEM image is displayed on a display device 14.

The sample 12 to be observed is mounted on the stage 11 placed in the sample chamber 3. The stage 11 moves and rotates the sample 12, and has a degree of freedom, such as a horizontal direction (XY direction), an up-down direction (Z direction), rotation (rotation around the Z axis), or inclination (in the drawing, only one degree of freedom is shown). Stage control means 15 controls the stage 11 in accordance with an input from stage operation input means 16 which is an input device, such as a trackball or a joystick. As the stage operation input means 16, a PC connected through a network or a serial interface may be used.

A sample surface to be observed is selected by positioning the stage 11. The operator operates the stage operation input means 16 while viewing the SEM image, and moves the stage 11 until an intended region to be observed is obtained as an SEM image. When observing a sample, such as a semiconductor wafer, in which the same fine patterns (cells) are continuous, a method which inputs a movement direction and speed from the stage operation input means 16 to the stage control means 15 to move the stage 11 at constant speed, and measures the number of cells passing across the SEM image screen through visual observation of the operator or image processing to determine whether or not an intended region has been reached is used.

A mechanism portion of the stage apparatus of this example will be described with reference to Fig. 3. In the stage 11, a sample is attached to a movable table 101, and the movable table 101 is moved along guide rails 102 attached to a base 100 to move the sample. A linear actuator is used as driving means for moving the movable table. The linear actuator has a shaft 103 and a motor 104, and if a driving signal is input to the motor 104, the motor 103 moves along the shaft 103. The motor 104 is attached to the movable table 101, and the shaft 103 is attached to the base. The shaft 103 may be attached to the movable table 101, and the motor 104 may be attached to the base.

As position detection means for detecting the position of the movable table 101, for example, a linear scale having a scale 105 and a sensor head 106 is used. The scale 105 has slits at regular intervals, and a pulse is generated each time the sensor head 106 passes above each slit. The number of pulses is measured, thereby acquiring the position. The scale 105 is attached to the base 100, and the sensor head is attached to the movable table 101. As the position detection means, a laser interferometer, a laser displacement meter, or the like may be used.

The stage control means 15 performs control computation from a command value input from the stage operation input means 16 and position information detected by the position detection means, and outputs a driving signal to the motor 104 to operate the stage.

Although Fig. 3 shows the configuration of the stage having one degree of freedom, the same stage may be combined, thereby constituting a stage having multiple degrees of freedom.

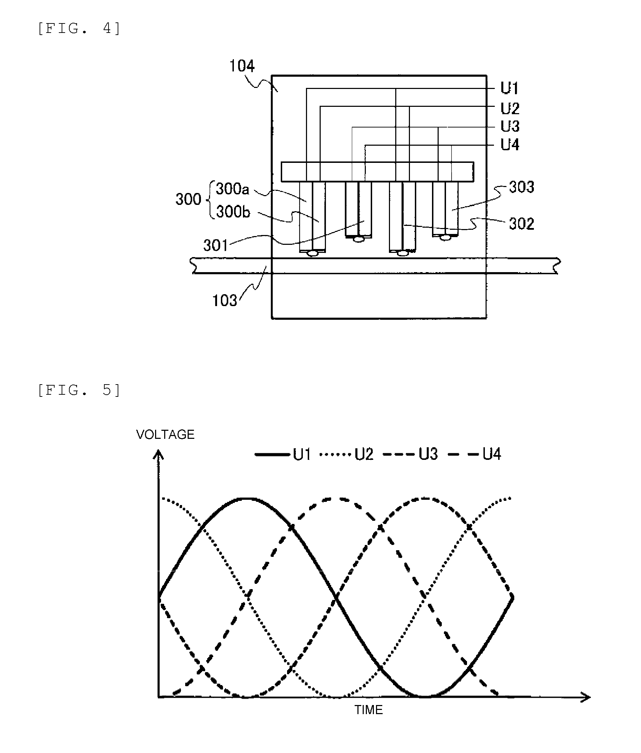

An example of the configuration of the driving means which is used in the stage of this example and the driving signal for driving the driving means will be described with reference to Figs. 4 and 5. Inside the motor 104 are driving elements 300, 301, 302, and 303 each having laminated piezoelectric plates 300a and 300b pasted together, and the tip of each driving element is pressed against the shaft 103 by a spring (not shown). If the driving signals are provided to the laminated piezoelectric plates pasted together, the driving element can expand and contract or can be bent depending on the sum and difference of the signals. Accordingly, the driving signals are prepared such that the tip of the driving element draws an elliptical orbit, and the driving signals are provided with a shift in phase between a combination of 300 and 302 and a combination of 301 and 303. Thus, the motor can move along the shaft while the driving element of each phase is repetitively attached to and detached from the shaft. Fig. 5 shows the waveform of a driving signal for one cycle, and when the motor is continuously moved, the waveform may be repetitively provided. This is one configuration example of the driving means, and is not intended to limit the technical idea of the invention.

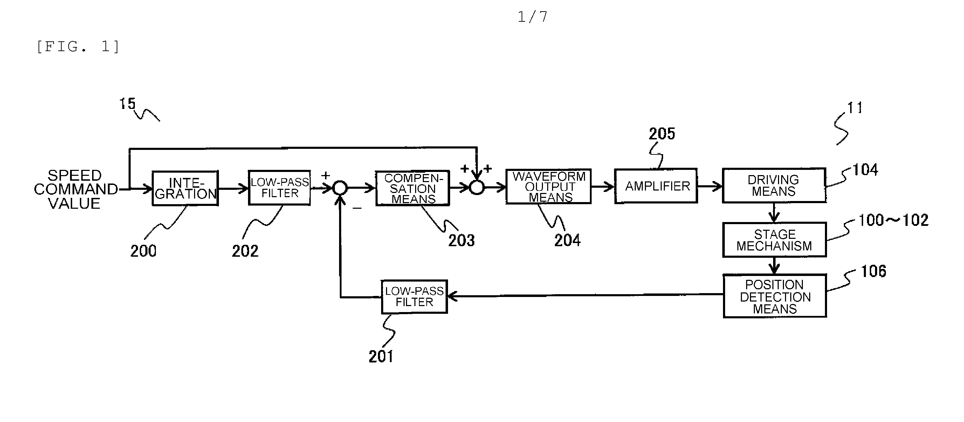

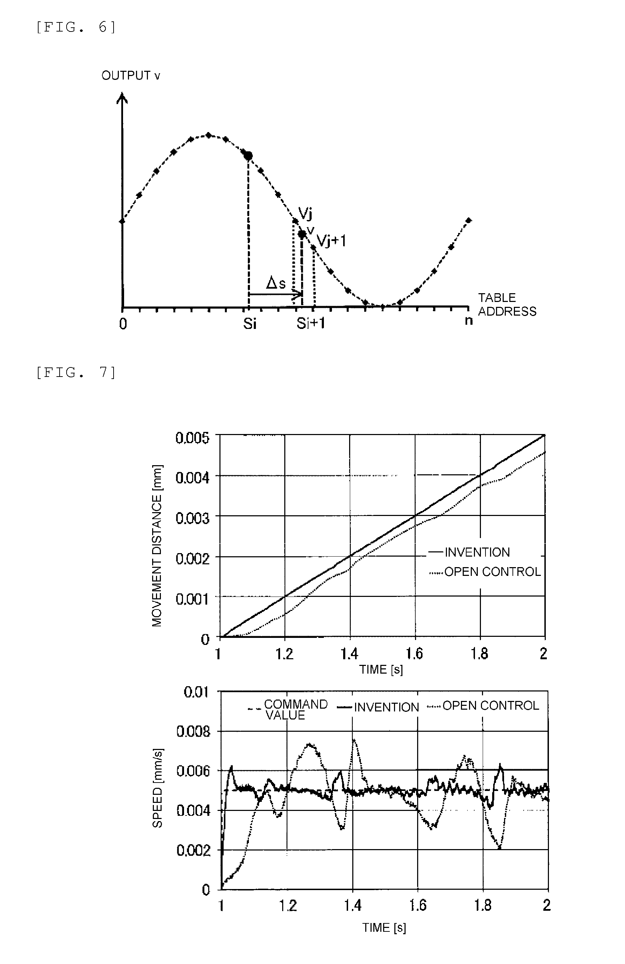

The configuration and operation of the stage apparatus of this example will be described with reference to Figs. 1 and 6. In the stage apparatus of this example, compensation computation is performed by compensation means 203 from the deviation between a signal having passed through a first low-pass filter 201 which removes a noise component from position information acquired from the position detection means 106 and a signal obtained from the speed command value input from the stage operation input means 16 through an integrator 200 and a second low-pass filter. At this time, the second low-pass filter 202 has the same frequency characteristic as the first low-pass filter. In the compensation means 204, for example, compensation, such as PID, is performed. Waveform output means 204 outputs a driving signal from a signal obtained by adding the speed command value to the output of the compensation means 203 by a method described below, and the driving signal is amplified by an amplifier 205 and output to driving means 104.

The outline of processing in the waveform output means 204 will be described with reference to Fig. 6. The waveform output means stores a driving signal waveform for driving the driving means shown in Fig. 5 in a table format. An index S indicating a reference position of the table is a real number. When an input ΔS is provided to the waveform output means, ΔS is added to a previous index Si to obtain a current index Si+1. An output v from the waveform output means at this time is computed by extracting table storage values Vj and Vj+1 at addresses corresponding to integers Pj and Pj+1 before and after Si+1 and performing interpolation. Accordingly, it is possible to generate continuous output signals, and to solve discontinuity of a command value due to errors in the quantization of the table which is problematic when the stage is operated at very low speed.

In the stage apparatus of this example, compensation is performed by means of the deviation between an integrated value of the speed command value and the position detected by the position detection means. For this reason, the influence of errors during the estimation of speed at very low speed in the related art is eliminated, thereby realizing a stable operation. A noise component at the position detected by the position detection means is reduced using the first low-pass filter. At this time, the placement of the first low-pass filter causes delay in response. Accordingly, the second low-pass filter having the same frequency characteristic as the first low-pass filter is placed on the integrated value of the speed command value, thereby eliminating shift in phase.

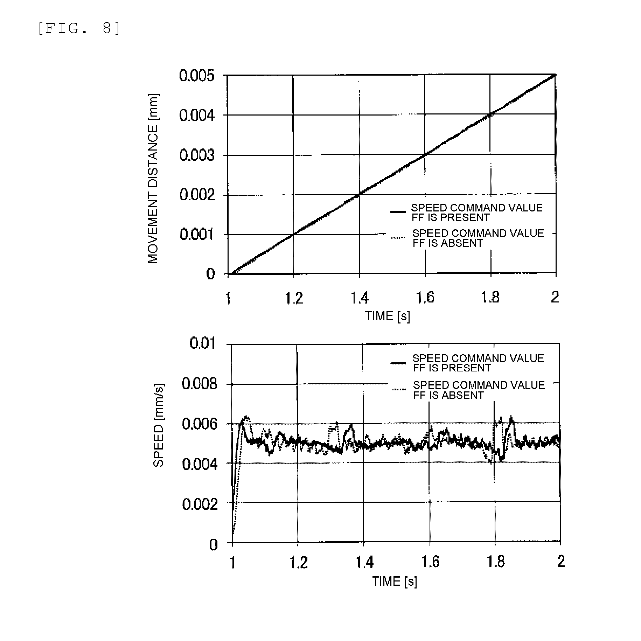

The operation result of the stage apparatus of this example will be described with reference to Figs. 7 and 8. Fig. 7 shows temporal changes in movement distance and speed when the stage is moved at constant speed using open control and the stage apparatus of this example. While fluctuation in speed is observed through open control, in this example, fluctuation in speed can be reduced. In the open control, while delay in response at the time of beginning is observed, in this example, delay in response can be improved. Fig. 8 shows temporal changes in movement distance and speed when the stage is moved at constant speed between a case where the speed command value is added to the input to the waveform output means (the speed command value FF is present) and a case where the speed command value is not added (the speed command value FF is absent) in the stage apparatus of this example. From this, it can be understood that, in a case where the speed command value is added, the effect of reducing fluctuation in speed (in particular, suppressing high-frequency vibration) and improving delay in response is large.

As described above, with the use of the stage apparatus of this example, it is possible to reduce fluctuation in speed during low-speed movement and to improve delay in response.

The frequency characteristics, such as a cutoff frequency, of the first low-pass filter 201 and the second low-pass filter 202 may change depending on the speed command value. The first low-pass filter removes a noise component included in the position information acquired by the position detection means. For this reason, when the stage moves at low speed, it is preferable to set the cutoff frequency of the low-pass filter to be low, thereby suppressing mixing of noise in a control system as much as possible. However, if the movement speed of the stage becomes high, variation in position information due to fluctuation in speed caused by deformation of the driving means/the driving force transmission system of the stage, which will be intrinsically suppressed, may be removed. Accordingly, when the speed command value is high, the cutoff frequency of the low-pass filter increases. Thereby, the effect of reducing fluctuation in speed can be improved.

Various gains of the compensation means 203 may change depending on the speed command value. When the stage moves at low speed, a proportional gain of the compensation means increases, thereby increasing the effect of reducing fluctuation in speed and improving delay in response. However, if the movement speed becomes high, since noise mixed in position information increases, it may be preferable that, in addition to noise removal using the low-pass filter, the proportional gain or the like decreases to reduce the influence of noise. Thus, it is possible to improve the effect of reducing fluctuation in speed and to improve stability of a control system.

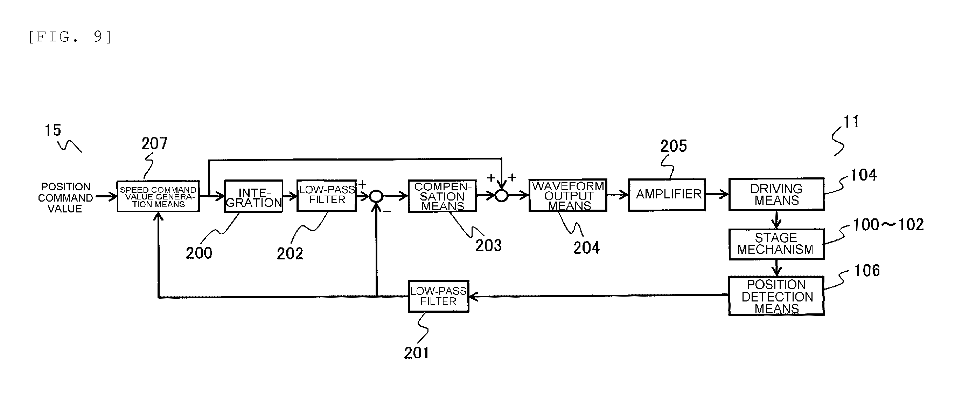

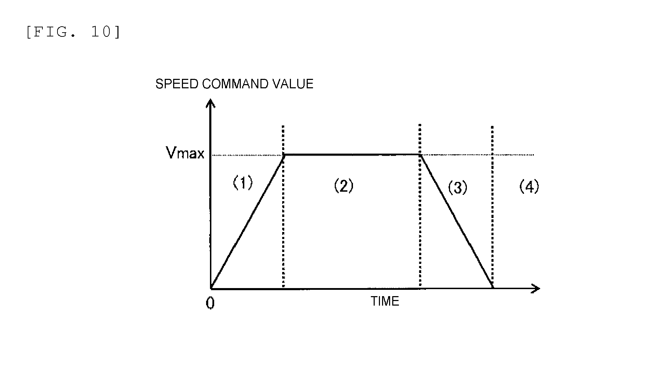

Another embodiment of this example will be described with reference to Figs. 9 and 10. Fig. 9 shows another configuration example of the stage apparatus of this example. In this configuration, speed command value generation means 207 for generating a speed command value from a provided position command value (a target position to be reached) and position information obtained from the position detection means 106 through the first low-pass filter 201 is provided.

In the speed command value generation means 207, for example, a speed pattern shown in Fig. 10 is generated and output. The speed pattern has the following four phases.
(1) The speed command value increases at an acceleration set in advance.
(2) The speed command value is maintained after the speed command value reaches a set speed Vmax.
(3) The command speed decreases at a deceleration set in advance after the current position reaches a deceleration start position.
(4) Movement at very low speed and positioning at a target position are done after the current position reaches near the position command value.

This is an example of speed command value generation, and it should suffice that a speed pattern in which speed changes smoothly may be generated. This is not intended to limit the technical idea of the invention.

In this way, it is possible to provide a stage capable of reducing fluctuation in speed even if a position command value (a final target position) is provided.

### Reference Signs List

1: scanning electron microscope
2: lens barrel
3: sample chamber
4: electron gun
5: primary electron beam
6: convergence lens
7: objective lens
8: scanning polarizer
9: secondary electron
10: secondary electron detector
11: stage
12: sample
13: electronic optical system control means
14: display device
15: stage control means
16: stage operation input means
100: base
101: movable table
102: guide rail
103: shaft
104: motor
105: scale
106: sensor head
200: integrator
201, 202: low-pass filter
203: compensation means
204: waveform output means
205: amplifier
207: speed command value generation means

## Claims

1. A stage apparatus comprising:
a stage which moves with a sample mounted thereon;
driving means for driving the stage;
position detection means for detecting the position of the stage;
stage operation input means for operating the stage;
stage control means for controlling the stage in accordance with an input from the stage operation input means;
a first low-pass filter which processes position information detected by the position detection means;
an integrator which integrates a speed command value input from the stage operation input means;
a second low-pass filter which processes the output of the integrator and has the same frequency characteristic as the first low-pass filter;
compensation means for performing control computation from the deviation between the output of the first low-pass filter and the output of the second low-pass filter;
waveform output means for generating a driving signal to be input to the driving means from the addition value of the output of the compensation means and the speed command value; and
an amplifier which amplifies the output of the waveform output means and outputs the result to the driving means.

2. The stage apparatus according to claim 1,
wherein the frequency characteristics of the first low-pass filter and the second low-pass filter change depending on the speed command value.

3. The stage apparatus according to claim 1 or 2,
where parameters of the compensation means change depending on the speed command value.

4. The stage apparatus according to any one of claims 1 to 3,
wherein a piezoelectric actuator is used as the driving means.

5. The stage apparatus according to any one of claims 1 to 4,
wherein the stage apparatus is used in a charged particle beam apparatus.

6. The stage apparatus according to any one of claims 1 to 5, further comprising:
speed command value generation means for generating the speed command value from a position command value input from the stage operation input means and the output of the first low-pass filter,
wherein the output of the speed command value generation means is used as an input to the integrator.
